# EUROPEAN PATENT SPECIFICATION

(11) **EP 0 967 525 B1**
(45) Date of publication and mention of the grant of the patent: **16.11.2005**
(21) Application number: 99304744.8
(22) Date of filing: 17.06.1999
(51) Int. Cl.: G03F 7/20

(54) **Lithographic projection apparatus**
Lithographischer Projektionsapparat
Appareil de projection lithographique

(30) Priority: 23.06.1998 EP 98202084
(43) Date of publication of application: 29.12.1999
(73) Proprietor: ASML Netherlands B.V., 5504 DR Veldhoven (NL)
(72) Inventor: Butler, Hans, 5685 AC Best (NL); Warmerdam, Thomas Petrus Hendricus, 5503 CM Veldhoven (NL)
(74) Representative: Leeming, John Gerard

(56) References cited:
- EP-A- 0 634 700
- GB-A- 2 300 275
- US-A- 5 696 590

## Description

The invention relates to a lithographic projection apparatus comprising:
- a radiation system for supplying a projection beam of radiation;
- a mask table provided with a mask holder for holding a mask;
- a substrate table provided with a substrate holder for holding a substrate;
- a projection system for imaging an irradiated portion of the mask onto a target portion of the substrate;
- first driving means, for moving the mask table in a given reference direction substantially parallel to the plane of the table;
- second driving means, for moving the substrate table parallel to the reference direction so as to be synchronous with the motion of the mask table;

An apparatus of this type can be used, for example, in the manufacture of integrated circuits (ICs). In such a case, the mask (reticle) may contain a circuit pattern corresponding to an individual layer of the IC, and this pattern can then be imaged onto a target area (die) on a substrate (silicon wafer) which has been coated with a layer of photosensitive material (resist). In general, a single wafer will contain a whole network of adjacent dies which are successively irradiated through the reticle, one at a time. Each die is irradiated by progressively scanning the reticle pattern under the projection beam in a given reference direction (the "scanning" direction) while synchronously scanning the wafer table parallel or anti-parallel to this direction, thereby transferring an image of the irradiated reticle pattern onto the die. Since, in general, the projection system will have a magnification factor M (generally M < 1), the speed at which the wafer table is scanned will be a factor M lower than that at which the reticle table is scanned. More information with regard to lithographic devices as here described can be gleaned from International Patent Application WO 97/33205.

Up to very recently, apparatus of this type contained a single mask table and a single substrate table. However, machines are now becoming available in which there are at least two independently movable substrate tables; see, for example, the multi-stage apparatus described in Intemational Patent Applications WO 98/28665 and WO 98/40791. The basic operating principle behind such multi-stage apparatus is that, while a first substrate table is underneath the projection system so as to allow exposure of a first substrate located on that table, a second substrate table can run to a loading position, discharge an exposed substrate, pick up a new substrate, perform some initial alignment measurements on the new substrate, and then stand by to transfer this new substrate to the exposure position underneath the projection system as soon as exposure of the first substrate is completed, whence the cycle repeats itself; in this manner, it is possible to achieve a substantially increased machine throughput, which in turn improves the cost of ownership of the machine.

Lithographic apparatus may employ various types of projection radiation, such as ultra-violet light (UV), extreme UV, X-rays, ion beams or electron beams, for example. Depending on the type of radiation used and the particular design requirements of the apparatus, the projection system may be refractive, reflective or catadioptric, for example, and may comprise vitreous components, grazing-incidence mirrors, selective multi-layer coatings, magnetic and/or electrostatic field lenses, *etc.* The apparatus may comprise components which are operated in vacuum, and are correspondingly vacuum-compatible. As mentioned in the previous paragraph, the apparatus may have more than one wafer table and/or mask table.

The manufacture of ICs and other devices with such apparatus generally involves the replication of extremely fine sub-micron patterns, with an exceptionally high degree of positional accuracy. For this reason, it is essential to properly isolate various critical parts of the apparatus (such as the substrate table and mask table, for example) from spurious motion, vibration, mechanical shocks, *etc.* In general, this is achieved using such measures as carefully designed metrology frames, air-mounts, motional counterweights and dampers, which serve to isolate the apparatus' critical parts from most unwanted mechanical influences. However, such measures are not completely effective in eliminating a number of unwanted influences, such as, for example:
1. vibrations caused by mask handling devices (robots);
2. vibrations caused by motion of reticle masking blades;
3. resonance effects caused by the presence of air showers;
4. vibrations in the substrate table caused by motion of the mask table, and *vice versa.* Although these effects are relatively small, they become increasingly important as the need to produce ever-higher device resolutions increases, and they now form a substantial barrier to the viable realization of large-area ICs having critical dimensions of the order of 0.15 µm and less.

US 5,696,590, GB-2,300,275-A and EP-0 637 700-A all disclose lithographic apparatus in which a substrate table position error is corrected in the positioning of the mask stage.

It is an object of the invention to alleviate this problem. More specifically, it is an object of the invention to provide a step-and-scan lithographic projection apparatus in which the effects of the above-mentioned disturbances are reduced. In particular, it is an object of the invention that the said apparatus should contain means to counteract motional asynchronism between the substrate table and mask table arising as a result of such disturbances.

These and other objects are achieved in an apparatus and method as specified in the appended claims.

The invention is founded upon the insight that the disturbances referred to above are substantially impossible to remove using solely structural alterations to the lithographic apparatus, and that the only practical solution is to employ an approach based on Control Theory. In experiments leading to the invention, the inventors attempted to correct servo errors in the substrate table by using the second measuring means to quantify such errors (by comparing the substrate table's measured and intended positions), and employing a feedback loop to the second driving means to iteratively remove such errors. However, although this approach produced a certain improvement, it failed to remove all unwanted disturbances; further analysis showed that disturbances with characteristic frequencies of the order of about 200 Hz were not being satisfactorily attenuated using this plan of attack, although lower-frequency disturbances *(e.g.* 20-80 Hz) did demonstrate a reduced amplitude.

In a fresh approach to the problem, the inventors abandoned the idea of attempting to completely remove the effects of unwanted motional disturbances in the substrate table, and turned their attention instead to the mask table. Because the mask table generally has a less complex and more lightweight construction than the substrate table, it was expected that the former would have a less complex resonance signature than the latter. Experiments verified that this was indeed the case, but, at frequencies of the order of about 200 Hz, the amplitude of the disturbances in the mask table was substantially equal to that of those in the substrate table.

However, the inventors next arrived at the insight that, since mask features were projected onto the substrate with a magnification M < 1 (typically M = 1/4 or 1/5), the magnitude of mask-table disturbances as seen from the substrate table would be greatly reduced. Instead of trying to wholly eliminate unwanted disturbances from the substrate table, one could thus alternatively attempt to compensate for any residual disturbances by using appropriate mask table adjustments, wherewith the current invention was conceived. Subsequent experiments using this approach yielded excellent results.

Position errors in the mask table can be combated by using the first measuring means to quantify such errors (by comparing the mask table's measured and intended positions), and employing a feedback loop to the first driving means to iteratively reduce such errors.

An imperfection of such a feedback loop can arise due to the fact that the bandwidth of such a mask-table feedback loop is typically of the order of about 150-175 Hz, which is below the range of frequencies 175-225 Hz characteristic of the most persistent motional disturbances in the apparatus; consequently, if disturbances in this latter frequency range are offered to the input of the mask-table feedback loop, they will not be optimally combated. To circumvent this problem, in the invention at least a portion of the *position* error signal is differentiated twice with respect to time before being passed to the correction means, thus providing the correction means with an *acceleration* error signal. This can then be fed directly to the first driving means instead of being offered to the input of the mask-table feedback loop; by multiplying the acceleration error by the mass of the mask table, one immediately obtains the force required to correct the mask table position.

An embodiment of the apparatus according to the invention is characterized in that at least a portion of the position error signal is passed to the correction means *via* a lead/lag filter, which filter serves to compensate for any intrinsic temporal inertia (time delay) in the compensation means. This measure ensures that the compensation produced by adjustment of the mask table does not lag behind the original servo error in the substrate table to such an extent as to significantly reduce the image positioning accuracy of the apparatus.

In the light of the discussion in the previous paragraph, it should be noted that the use of an optical fiber link to carry the error signal to the correction means also helps reduce the occurrence of unwanted system lag.

In a particular refinement of the embodiment above, the lead/lag filter is adjusted for optimal performance within that part of the frequency spectrum in which the position error signal has its greatest amplitude. In a specific example, the filter is embodied for optimal performance in the range 175-225 Hz.

In another embodiment of the apparatus according to the invention, position errors in the substrate table are quantified using the second measuring means (by comparing the substrate table's measured and intended positions), and use is made of a feedback loop to the second driving means to iteratively reduce such errors. Such a measure acts in unison with the basic inventive method so as to help reduce inaccuracies in the relative positions of the mask and substrate tables.

In the above, the desired momentary position (setpoint) of the substrate table and/or mask table may, for example, be derived from a (software) setpoint generator which generates a (mathematical) profile for the desired/dictated synchronized motion of the two tables. It should be noted that the fixed reference point with respect to which the position of the substrate table is measured, and the fixed reference point with respect to which the position of the mask table is measured, may be identical or distinct, according to choice.

In a manufacturing process using a lithographic projection apparatus according to the invention, a pattern in a mask is imaged onto a substrate which is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e.g.* an IC.
Such a patterned layer may then undergo various processes such as etching, ion-implantation (doping), metallization, oxidation, chemo-mechanical polishing, *etc.,* all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, *etc.* Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference has been made hereabove to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, *etc.* The skilled artisan will appreciate that, in the context of such alternative applications, any use of the terms "reticle", "wafer" or "die" in this text should be considered as being replaced by the more general terms "mask", "substrate" and "target area", respectively.

The invention and its attendant advantages will be further elucidated with the aid of exemplary Embodiments and the accompanying schematic drawings, wherein:
Figure 1 is a schematic representation of a Control Theory circuit suitable for implementation in an apparatus according to the invention;
Figure 2 depicts the frequency response of the mask table and substrate table in a particular embodiment of an apparatus according to the invention;
Figure 3 renders a general schematic view of an apparatus according to the invention.

Corresponding features in the various Figures are denoted by the same reference symbols.

### Embodiment 1

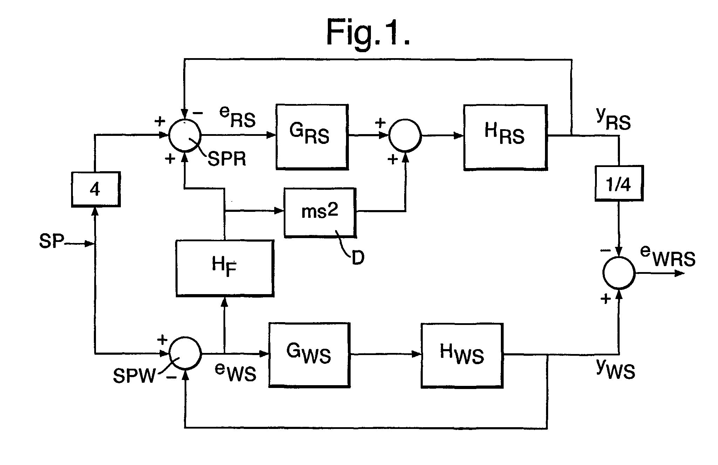

Figure 1 depicts a particular embodiment of a correctional schematic for use in an apparatus according to the invention. The top loop represents the mask table (or reticle stage: RS), consisting of the mechanical transfer *H*_{*RS*} and controller *G*_{*RS*}. The bottom loop is the substrate table (or wafer stage: WS), consisting of the mechanical transfer *H*_{*WS*} and controller *G*_{*WS*}. The reticle stage receives 4x the setpoint SP of the wafer stage, while its output only counts ¼ in the relevant WS/RS error

In addition to a low-pass filter *H*_{*F*} (with gain - 4) which feeds the WS error *e*_{*WS*} to the RS setpoint SPR, a double differentiator D generates the WS *acceleration error.* By multiplication of this acceleration by the RS mass (*m*), an extra force is generated which, when applied to the reticle stage, should give the RS the same acceleration as the WS. *H*_{*F*} may also contain a lead/lag component to optimize the feedthrough in a specific frequency range, as discussed further in Embodiment 2 below.

When applied on its own, the RS controller would consider this force a disturbance, and would react and try to diminish the effect of the feedforward. By additionally feeding the filtered WS error to the RS setpoint, this problem is solved. Now, if the RS reacts to the extra feedforward force as a transfer ¹/_{*ms*²}, the RS error *e*_{*RS*} remains zero and hence the RS controller is left "unaware" of any extra force injection.

The main advantage of this feedthrough form is its independence of the RS bandwidth. Even with low bandwidths, the extra force feedforward creates the required RS response. Only when the RS dynamics deviate from the ideal ¹/_{*ms*²} will the RS response become non-ideal.

Note that, for implementation purposes, the actual filter architecture can be chosen slightly differently. For example, two filters having the same denominator polynomial can be used; in that case, only the numerator differs, the low-pass filter having only a gain, the high-pass filter having the term *m.s*^{*2*}.

### Embodiment 2

When using the feedthrough method shown in Figure 1, the main cause of residual WS/RS error is the phase difference at higher frequencies. This phase lag is caused by the remaining delay in the path from WS error to RS.

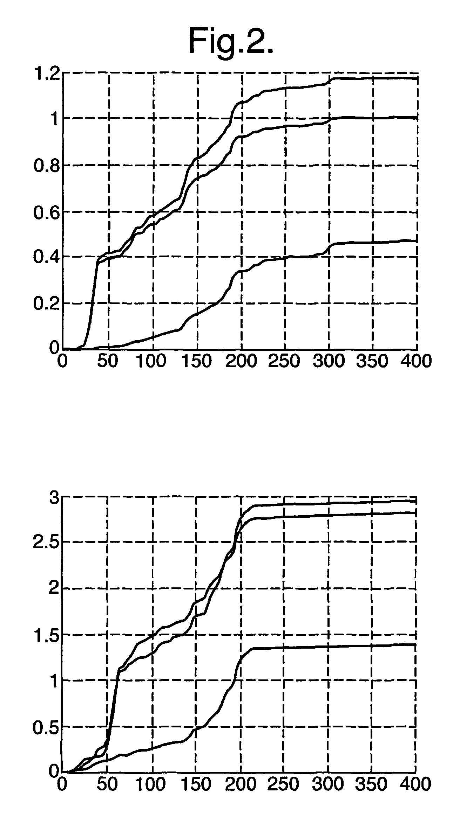

Figure 2 shows the frequency spectra of the WS position error (top line), of the RS position error divided by 4 (just below top line), and of the net error at WS level (bottom line), in the orthogonal directions X (top Figure) and Y (bottom Figure) defining the plane of the WS, Y being the scanning direction. The horizontal axes depict frequency in Hz; the numbers along the vertical axes are x 10⁻¹³. As can be seen, the RS follows the WS quite accurately when it comes to the amplitude of the error. Particularly at low frequencies, this results in a residual WS/RS error of relatively small magnitude. However, for frequencies between 175 and 225 Hz, although the RS error matches the WS error fairly well in amplitude, the residual error becomes relatively large. This effect is most obvious in the Y direction. This rise of the net error is caused by the phase difference between the WS error and the RS reaction.

Decreasing the phase difference by adding a lead/lag filter improves the net error at WS level. After various optimization cycles, a lead/lag filter was selected having damping ratios of 0.3 for both numerator and denominator (so as to keep the overshoot low), with a zero frequency at 175 Hz and a pole frequency at 205 Hz.

The table below shows the magnitude of the net WS/RS errors obtained using such a filter (column "filter"), as compared to the results obtained using a set-up as depicted in Figure 1 (column "loop") and the raw results obtained without application of the current invention (column "uncorrected"). MA and MSD are the moving average and moving standard deviation, respectively. All figures are in nm, and are quoted for the X and Y directions discussed above.

| | uncorrected | loop | filter |
|---|---|---|---|
| MA X | 11.4 | 1.4 | 1.0 |
| MSD X | 14.9 | 7.9 | 6.9 |
| MA Y | 4.3 | 1.6 | 1.1 |
| MSD Y | 22.7 | 15.8 | 9.3 |

### Embodiment 3

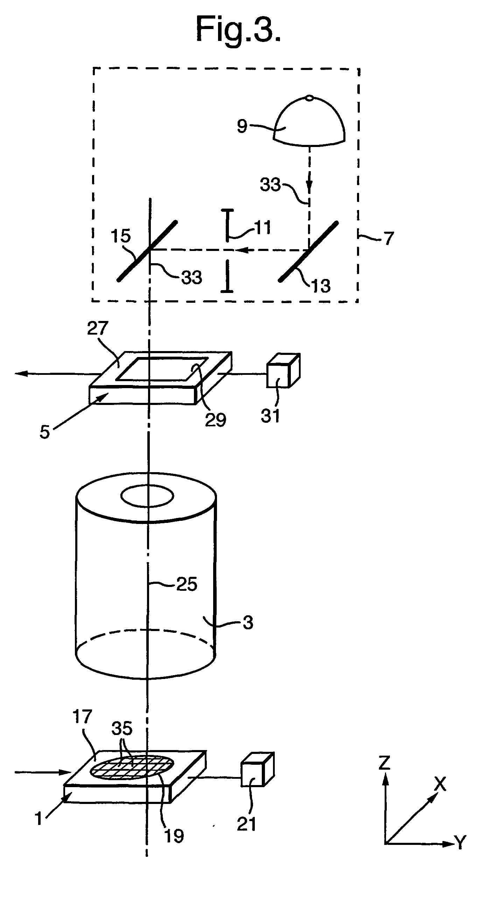

Figure 3 renders a schematic perspective view of a lithographic projection apparatus according to the invention. The apparatus comprises:
- a radiation system 7 for supplying a projection beam 33 of radiation *(e.g.* ultraviolet light, EUV, X-rays or a charged particle beam);
- a mask table 5 provided with a mask holder 27 for holding a mask 29 *(e.g.* a reticle);
- a substrate table 1 provided with a substrate holder 17 for holding a substrate 19 *(e.g.* a resist-coated silicon wafer);
- a projection system 3 *(e.g.* a lens or catadioptric system, a mirror group, or a charged particle imaging system) for imaging an irradiated portion of the mask 29 onto a target portion 35 (die) of the substrate 19.
As here depicted, the apparatus is transmissive, *i.e.* contains a transmissive mask and projection system. However, the apparatus may also be reflective, with a reflective mask and/or projection system, for example.

The radiation system 7 comprises a source 9 *(e.g.* a Hg lamp or excimer laser, a charged particle source (such as a thermionic cathode), or an undulator provided around the path of an electron beam in a storage ring or synchrotron) which produces a beam 33 of radiation. This beam 33 is passed along various illuminator components 11,13,15 so that the beam 25 emerging from the system 7 is substantially collimated and uniformly intense throughout its cross-section.

The projection beam subsequently intercepts a reticle 29 which is held in a mask holder 27 on a mask table 5. With the aid of first driving means 31, the mask table 5 can be moved accurately back and forth along the Y-direction (the so-called scanning direction).

Having passed through the reticle 29, the projection beam passes through a projection system 3, which focuses the beam 25 onto a die 35 of the wafer 19. With the aid of second driving means 21, the substrate table 1 can also be moved accurately back and forth along the Y-direction (scanning direction). The substrate table 1 can also be moved back and forth in the X-direction, and additionally has other degrees of freedom.

During a scan, the reticle table 5 is moved in the scan direction with a speed *v,* so that the projection beam is caused to scan over a reticle image. Simultaneously, the substrate table 1 is moved in the same or opposite direction at a speed *V* = *Mv,* in which *M* is the magnification of the projection system 3 (typically, *M =* 1/4 or 1/5). In this manner, a relatively large die can be exposed, without having to compromise on resolution.

The current invention is implemented in this set-up to help ensure proper synchronization of the scanning motion of the mask table 5 and substrate table 1, as explained in Embodiment 1.

## Claims

1. A lithographic projection apparatus comprising:
a radiation system (7) for supplying a projection beam (33) of radiation;
a mask table (5) provided with a mask holder (27) for holding a mask (29);
a substrate table (1) provided with a substrate holder (17) for holding a substrate (19);
a projection system (3) for imaging an irradiated portion of the mask (29) onto a target portion (35) of the substrate (19);
first driving means (31), for moving the mask table (5) in a given reference direction substantially parallel to the plane of the table;
second driving means (21), for moving the substrate table (1) parallel to the reference direction so as to be synchronous with the motion of the mask table (5);
first measuring means, for determining the momentary position of the mask table with respect to a fixed reference point;
second measuring means, for determining the momentary position of the substrate table with respect to a fixed reference point, and
means (SPW) for comparing the measured momentary position of the substrate table with a desired momentary position of the substrate table, for generating a position error signal in accordance with a difference between the said two positions, and for passing that signal to correction means which serve to adjust the momentary position of the mask table so as to compensate for such difference;
**characterized by**:
a means arranged to scale the position error signal, means arranged to differentiat at least a portion of the scaled position error signal twice with respect to time to generate an acceleration error signal and to multiply said acceleration error signal by the mass of the mask table to generate a force signal; and
means arranged to supply said force signal to the first driving means (31) thereby to provide said mask table with substantially the same scaled acceleration as said substrate table.

2. An apparatus according to Claim 1 wherein at least a portion of the position error signal is passed to the correction means *via* a lead/lag filter (H_{F}), which filter serves to compensate for any intrinsic temporal inertia in the compensation means.

3. An apparatus according to Claim 2, wherein the filter (H_{F}) is adjusted for optimal performance within that part of the frequency spectrum in which the position error signal has its greatest amplitude.

4. An apparatus according to Claim 2 or 3, wherein the filter (H_{F}) is adjusted for optimal performance within the frequency range 175-225 Hz.

5. An apparatus according to any of the Claims 1-4, wherein the apparatus comprises a first comparator for comparing the measured momentary position of the mask table (15) with a desired momentary position thereof, for generating a first signal dependent on any difference between these two positions of the mask table, and for passing that signal to the first driving means (31) so as to adjust the momentary position of the mask table and thus reduce the said difference.

6. An apparatus according to any of the Claims 1-5, wherein the apparatus comprises a second comparator for comparing the measured momentary position of the substrate table with a desired momentary position thereof, for generating a second signal dependent on any difference between these two positions of the substrate table, and for passing that signal to the second driving means so as to adjust the momentary position of the substrate table and thus reduce the said difference.

7. An apparatus according to any of Claims 1-6, wherein the position error signal is passed to the correction means *via* an optical fiber link.

8. A device manufacturing method comprising the steps of:
providing a mask (29) which contains a pattern on a mask table (5) which is connected to first driving means (31), for moving the mask table (5) in a given reference direction parallel to the plane of the table;
providing a substrate (19) which is at least partially covered by a layer of radiation-sensitive material on a substrate table (1) which is connected to second driving means (21), for moving the substrate table (1) parallel to the reference direction so as to be synchronous with the motion of the mask table (5);
using a projection beam (33) of radiation to project an image of at least part of the mask pattern onto a target area of the layer of radiation-sensitive material;
using first measuring means to determine the momentary position of the mask table with respect to a fixed reference point;
using second measuring means to determine the momentary position of the substrate table with respect to a fixed reference point;
comparing the measured momentary position of the substrate table with a desired momentary position of the substrate table, to generate a position error signal in accordance with a difference between the said two positions, and passing that signal to correction means which serve to adjust the momentary position of the mask table so as to compensate for the said difference; **characterized by**:
scaling said position error signal, differentiating at least a portion of said scaled position error signal twice with respect to time to generate an acceleration error signal and multiplying said acceleration error signal by the mass of said mask table to generate a force signal; and
supplying said force signal to the first driving means (31) so that said mask table has substantially the same scaled acceleration as said substrate table.

## Patentansprüche

1. Lithografische Projektionsvorrichtung, folgendes umfassend:
ein Strahlungssystem (7) zum Abgeben eines Projektionsstrahls (33) aus Strahlung;
einen Maskentisch (5), der mit einem Maskenhalter (27) versehen ist, um eine Maske (29) zu halten;
einen Substrattisch (1), der mit einem Substrathalter (17) versehen ist, zum Halten eines Substrates (19);
einem Projektionssystem (3) zum Abbilden eines bestrahlten Bereichs der Maske (29) auf einen Zielabschnitt (35) des Substrates (19);
einen erste Antriebseinrichtung (31) zum Bewegen des Maskentisches (5) in einer gegebenen Bezugsrichtung, die im wesentlichen parallel ist zur Ebene des Tisches;
eine zweite Antriebseinrichtung (21) zum Bewegen des Substrattisches (1) parallel zu der Bezugsrichtung derart, dass die Bewegung synchron ist mit der Bewegung des Maskentisches (5);
eine erste Messeinrichtung zum Bestimmen der momentanen Position des Maskentisches in Bezug auf einen festen Bezugspunkt;
eine zweite Messeinrichtung zum Bestimmen der momentanen Position des Substrattisches in Bezug auf den festen Bezugspunkt, und
eine Einrichtung (SPW) zum Vergleichen der gemessenen momentanen Position des Substrattisches mit einer gewünschten momentanen Position des Substrattisches, zur Erzeugung eines Positionsfehlersignals entsprechend der Differenz zwischen den beiden genannten Positionen, und zum Weitergeben dieses Signals an eine Korrektureinrichtung, die dazu dient, die momentane Position des Maskentisches anzupassen, sodass die Differenz kompensiert ist;
**gekennzeichnet durch**:
eine Einrichtung, die eingerichtet ist, das Positionsfehlersignal zu skalieren, eine Einrichtung, die eingerichtet ist, zumindest einen Teil des skalieren Positionsfehlersignals zweimal in Bezug auf die Zeit abzuleiten, um ein Beschleunigungsfehlersignal zu erzeugen, und um eine Multiplikation des Beschleunigungsfehlersignals mit der Masse des Maskentisches durchzuführen, um ein Kraftsignal zu erzeugen; und
eine Einrichtung, die eingerichtet ist, das genannte Kraftsignal an die erste Antriebseinrichtung (31) zu übertragen und so dafür zu sorgen, dass der Maskentisch im wesentlichen die gleiche skalierte Beschleunigung aufweist wie der Substrattisch.

2. Vorrichtung gemäß Anspruch 1, wobei zumindest ein Teil des Positionsfehlersignals über ein Führungs-/Verzögerungsfilter (H_{F}) zu der Korrektureinrichtung gelangt, wobei das Filter dazu dient, immanente zeitliche Trägheiten in der Kompensationseinrichtung zu kompensieren.

3. Vorrichtung nach Anspruch 2, wobei das Filter (H_{F}) auf denjenigen Teil des Frequenzspektrums optimiert ist, in dem das Positionsfehlersignal seine größte Amplitude hat.

4. Vorrichtung gemäß einem der Ansprüche 1 oder 2, wobei das Filter (H_{F}) in dem Frequenzbereich von 175-225 Hz seine optimale Leistung aufweist.

5. Vorrichtung nach einem der Ansprüche 1 bis 4, wobei die Vorrichtung einen ersten Komparator aufweist zum Vergleichen der gemessenen momentanen Position des Maskentisches (15) mit der gewünschten momentanen Position desselben, um ein erstes Signal zu erzeugen, das von irgendeiner Differenz zwischen diesen beiden Positionen des Maskentisches abhängt, und zum Übertragen dieses Signals an die erste Antriebseinrichtung (31), sodass die momentane Position des Maskentisches eingestellt und somit die genannte Differenz reduziert wird.

6. Vorrichtung gemäß einem der Ansprüche 1 bis 5, wobei die Vorrichtung einen zweiten Komparator aufweist zum Vergleichen der gemessenen momentanen Position des Substrattisches mit einer gewünschten momentanen Position desselben, um ein zweites Signal zu erzeugen, das von einer Differenz zwischen diesen beiden Positionen des Substrattisches abhängt und um dieses Signal der zweiten Antriebseinrichtung zu übertragen, sodass die momentane Position des Substrattisches angepasst und somit die genannte Differenz reduziert wird.

7. Vorrichtung nach einem der Ansprüche 1 bis 6, wobei das Positionsfehlersignal über eine optische Faser-Verbindung an die Korrektureinrichtung übertragen wird.

8. Verfahren zum Herstellen eines Produktes, folgende Schritte umfassend:
Bereitstellen einer Maske (29), die ein Muster aufweist, auf einem Maskentisch (5), der mit einer ersten Antriebseinrichtung (31) verbunden ist, um den Maskentisch (5) in einer vorgegebenen Bezugsrichtung parallel zur Ebene des Tisches zu bewegen;
Bereitstellen eines Substrates (19), das zumindest teilweise mit einer Schicht aus einem strahlungsempfindlichen Material abgedeckt ist, auf einem Substrattisch (1), der mit einer zweiten Antriebseinrichtung (21) verbunden ist, um den Substrattisch (1) parallel zu der Bezugsrichtung zu bewegen derart, dass die Bewegung synchron ist mit der Bewegung des Maskentisches (5);
Verwendung einen Projektionsstrahls (33) aus Strahlung, um ein Bild zumindest eines Teils Maskenmusters auf eine Zielfläche auf der Schicht des strahlungsempfindlichen Materials abzubilden;
Verwendung einer ersten Messeinrichtung zur Bestimmung der momentanen Position des Maskentisches in Bezug auf einen festen Bezugspunkt;
Verwendung einer zweiten Messeinrichtung zur Bestimmung der momentanen Position des Substrattisches in Bezug auf den festen Bezugspunkt;
Vergleichen der gemessenen momentanen Position des Substrattisches mit einer gewünschten momentanen Position des Substrattisches, um ein Positionsfehlersignal entsprechend der Differenz zwischen den beiden genannten Positionen zu erzeugen, und
Weitergeben dieses Signals an eine Korrektureinrichtung, die dazu dient, die momentane Position des Maskentisches einzustellen, sodass die genannten Differenz kompensiert ist, **gekennzeichnet durch**:
ein Skalieren des genannten Positionsfehlersignals, ein zweifaches Differenzieren zumindest eines Teils des genannten skalierten Positionsfehlersignals in Bezug auf die Zeit, um ein Beschleunigungsfehlersignal zu erzeugen und ein Multiplizieren des genannten Beschleunigungsfehlersignals mit der Masse des Maskentisches, um ein Kraftsignal zu erzeugen; und
Eingeben des genannten Kraftsignals in die erste Antriebseinrichtung (31), sodass der Maskentisch im wesentlichen die gleiche skalierte Beschleunigung aufweist wie der Substrattisch.

## Revendications

1. Appareil de projection lithographique comportant :
un système de rayonnement (7) pour fournir un faisceau de projection (33) de rayonnement ;
une table de masque (5) munie d'un support de masque (27) pour supporter un masque (29) ;
une table de substrat (1) munie d'un support de substrat (17) pour supporter un substrat (19) ;
un système de projection (3) pour reproduire une image d'une partie irradiée du masque (29) sur une partie cible (35) du substrat (19) ;
des premiers moyens d'entraînement (31), pour déplacer la table de masque (5) dans une direction de référence donnée essentiellement parallèle au plan de la table ;
des seconds moyens d'entraînement (21), pour déplacer la table de substrat (1) parallèlement à la direction de référence de manière à être synchrone avec le mouvement de la table de masque (5) ;
des premiers moyens de mesure, pour déterminer la position instantanée de la table de masque par rapport à un point de référence fixe ;
des seconds moyens de mesure, pour déterminer la position instantanée de la table de substrat par rapport à un point de référence fixe, et
des moyens (SPW) pour comparer la position instantanée mesurée de la table de substrat à une position instantanée voulue de la table de substrat, pour générer un signal d'erreur de position en fonction d'une différence entre lesdites deux positions, et pour transmettre ce signal aux moyens de correction qui servent à ajuster la position instantanée de la table de masque de manière à compenser cette différence ;
**caractérisé par** :
des moyens agencés pour mettre à l'échelle le signal d'erreur de position, des moyens agencés pour différencier deux fois par rapport au temps au moins une partie du signal d'erreur de position mis à l'échelle pour générer un signal d'erreur d'accélération et pour multiplier ledit signal d'erreur d'accélération par la masse de la table de masque pour générer un signal de force ; et
des moyens agencés pour fournir ledit signal de force aux premiers moyens d'entraînement (31) de manière à affecter à ladite table de masque essentiellement la même accélération mise à l'échelle que celle de ladite table de substrat.

2. Appareil selon la revendication 1, dans lequel au moins une partie du signal d'erreur de position est transmise aux moyens de correction via un filtre à avance de phase/retard de phase (H_{F}), lequel filtre sert à compenser toute inertie temporelle intrinsèque dans les moyens de compensation.

3. Appareil selon la revendication 2, dans lequel le filtre (H_{F}) est ajusté pour une performance optimale dans la partie du spectre de fréquence dans laquelle le signal d'erreur de position a son amplitude la plus grande.

4. Appareil selon la revendication 2 ou 3, dans lequel le filtre (H_{F}) est ajusté pour une performance optimale dans la plage de fréquences de 175-225 Hz.

5. Appareil selon l'une quelconque des revendications 1 à 4, dans lequel l'appareil comporte un premier comparateur pour comparer la position instantanée mesurée de la table de masque (15) à une position instantanée voulue de celle-ci, pour générer un premier signal dépendant de toute différence entre ces deux positions de la table de masque, et pour transmettre ce signal aux premiers moyens d'entraînement (31) de manière à ajuster la position instantanée de la table de masque et ainsi réduire ladite différence.

6. Appareil selon l'une quelconque des revendications 1 à 5, dans lequel l'appareil comporte un second comparateur pour comparer la position instantanée mesurée de la table de substrat à une position instantanée voulue de celle-ci, pour générer un second signal dépendant de toute différence entre ces deux positions de la table de substrat, et pour transmettre ce signal aux seconds moyens d'entraînement de manière à ajuster la position instantanée de la table de substrat et réduire ainsi ladite différence.

7. Appareil selon l'une quelconque des revendications 1 à 6, dans lequel le signal d'erreur de position est passé dans les moyens de correction via une liaison à fibre optique.

8. Procédé de fabrication de dispositif comportant les étapes consistant à :
fournir un masque (29) qui contient un motif sur une table de masque (5) qui est reliée à des premiers moyens d'entraînement (31), pour déplacer la table de masque (5) dans une direction de référence donnée parallèle au plan de la table ;
fournir un substrat (19) qui est au moins partiellement recouvert d'une couche de matériau sensible au rayonnement sur une table de substrat (1) qui est reliée à des seconds moyens d'entraînement (21), pour déplacer la table de substrat (1) parallèlement à la direction de référence de manière à être synchrone avec le mouvement de la table de masque (5) ;
utiliser un faisceau de projection (33) de rayonnement pour projeter une image d'au moins une partie du motif de masque sur une zone cible de la couche de matériau sensible au rayonnement ;
utiliser des premiers moyens de mesure pour déterminer la position instantanée de la table de masque par rapport à un point de référence fixe ;
utiliser des seconds moyens de mesure pour déterminer la position instantanée de la table de substrat par rapport à un point de référence fixe ;
comparer la position instantanée mesurée de la table de substrat à une position instantanée voulue de la table de substrat, pour générer un signal d'erreur de positionnement en fonction d'une différence entre lesdites deux positions, et transmettre ce signal aux moyens de correction qui servent à ajuster la position instantanée de la table de masque de manière à compenser ladite différence ;
**caractérisé par** :
la mise à l'échelle dudit signal d'erreur de positionnement, la différenciation deux fois par rapport au temps d'au moins une partie dudit signal d'erreur de positionnement mis à l'échelle pour générer un signal d'erreur d'accélération et multiplier ledit signal d'erreur d'accélération par la masse de ladite table de masque pour générer un signal de force ; et
la fourniture dudit signal de force aux premiers moyens d'entraînement (31) de sorte que ladite table de masque a essentiellement la même accélération mise à l'échelle que celle de ladite table de substrat.
